# EUROPEAN PATENT APPLICATION

(11) **EP 4 495 983 A1**
(43) Date of publication of application: **22.01.2025**
(21) Application number: 23186798.7
(22) Date of filing: 20.07.2023
(51) Int. Cl.: H01L 21/67

(54) **SYSTEM AND METHOD FOR LOADING A SAMPLE TO A SAMPLE POSITION**

(71) Applicant: ASML Netherlands B.V., 5500 AH Veldhoven (NL)
(72) Inventor: MARTENS, Robby, Franciscus, Josephus, 5500 AH Veldhoven (NL); VAN DER TOORN, Jan-Gerard, Cornelis, 5500 AH Veldhoven (NL)
(74) Representative: ASML Netherlands B.V.

(57) **Abstract**

The present invention provides a method of loading a sample to a sample position. The method comprises loading a sample, having an initial voltage, on to a sample handler; ramping up the voltage of the sample from the initial voltage to a predetermined voltage, while the sample is on the sample handler; when the sample is at the predetermined voltage, transferring the sample from the sample handler to a sample position of a sample holder, wherein the sample position of the sample holder is at the predetermined voltage; and processing the sample at the sample position.

## Description

### FIELD

The embodiments provided herein generally relate to a system and method for loading a sample to a sample position.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment, e.g., inspection and/or measurement, of a surface of a substrate, or other object/material, is an important process during and/or after its manufacture.

Pattern assessment systems with a charged particle beam have been used to inspect objects, for example to detect pattern defects and to measure structural features on such objects. These tools typically use electron microscopy techniques, using electron optical systems for example in a scanning electron microscope (SEM). In exemplary electron optical system such a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over, or across, the sample surface, secondary electrons can be emitted across the surface of the sample. By collecting these emitted secondary electrons from the sample surface, a pattern assessment system (or assessment tool) may obtain an image representing characteristics of the material structure of the surface of the sample. The intensity of the electron beams comprising the backscattered electrons and the secondary electrons may vary based on the properties of the internal and external structures of the sample, and thereby may indicate whether the sample has defects.

There is a desire to increase the throughput of the assessment systems, such as for inspection, such that samples can be processed more quickly. In particular, there is a desire to increase throughput, for example to one wafer per hour. One technique to increase the throughput of assessment systems is to reduce the amount of time the sample spends in an inspection position when inspection is not taking place. For example, during inspection, the sample may be at a high voltage of approximately 10 to 45 kV. It is common for the sample to be placed in an inspection position while the voltage of the sample is increased from a ground voltage to the high voltage. This means that sample inspection is not taking place while the voltage of the sample is being increased prior to inspection and while the voltage of the sample is being decreased after inspection. The present invention therefore aims to increase throughput of samples by reducing time when the sample is in the inspection position but inspection is not taking place.

### SUMMARY

It is an object of the present disclosure to provide embodiments of a system and method for loading a sample to a sample position.

According to a first aspect of the invention, there is provided a method of loading a sample to a sample position. The method comprises loading a sample, having an initial voltage, on to a sample handler; ramping up the voltage of the sample from the initial voltage to a predetermined voltage, while the sample is on the sample handler; when the sample is at the predetermined voltage, transferring the sample from the sample handler to a sample position of a sample holder, wherein the sample position of the sample holder is at the predetermined voltage; and processing the sample at the sample position.

According to a second aspect of the invention, there is provided a system for loading a sample to a sample position. The system comprises a sample holder configured to support a sample at a sample position; a sample processor configured to process the sample disposed at the sample position; and a sample handler configured to hold the sample and transfer the sample to and from the sample position on the sample holder. The system is configured to: ramp up a voltage of the sample from an initial voltage to a predetermined voltage, while the sample is on the sample handler; and/or ramp down a voltage of the sample from the predetermined voltage to the initial voltage, while the sample is on the sample handler.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary electron beam assessment apparatus.
**FIG. 2** is a schematic diagram illustrating an exemplary multi-beam charged particle assessment system that is part of the exemplary electron beam assessment apparatus of **FIG. 1****.**
FIG. 3A-E is a series of schematic diagrams illustrating steps of a method for loading a sample to a sample position, wherein voltage is imparted from the sample holder to the sample by capacitive coupling as the sample moves along a path between two plates closer to the sample holder.
FIG. 4A-E is a series of schematic diagrams illustrating steps of a method for loading a sample to a sample position, wherein voltage is imparted from the sample holder to the sample by capacitive coupling as the sample, disposed in a conductive box, moves closer to the sample holder.
FIG. 5A-E is a series of schematic diagrams illustrating steps of a method for loading a sample to a sample position, wherein the voltage of the sample is ramped up by applying voltage to the sample handler.
FIG. 6A-E is a series of schematic diagrams illustrating steps of a method for loading a sample to a sample position, wherein the voltage of the sample is ramped up using a voltage controlled enclosure.
FIG. 7A-E is a series of schematic diagrams illustrating steps of a method for loading a sample to a sample position, wherein the voltage of the sample is ramped up using a voltage controlled tunnel.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus semiconductor IC manufacturing is a complex and time-consuming process, with many individual steps. An error in one of these steps has the potential to significantly influence the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by assessment systems (such as, or such as comprising, a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. Such an assessment apparatus may utilize a single primary electron beam incident on a sample. For high throughput inspection, some of the assessment apparatuses use multiple focused beams, i.e. a multi-beam, of primary electrons. The component beams of the multi-beam may be referred to as sub-beams or beamlets. The sub-beams may be arranged with respect to each other within the multi-beam in a multi-beam arrangement. A multi-beam can scan different parts of a sample simultaneously. A multi-beam assessment apparatus can therefore assess, for example inspect, a sample at a much higher speed than a single-beam assessment apparatus.

An implementation of known multi-beam assessment apparatus and systems is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

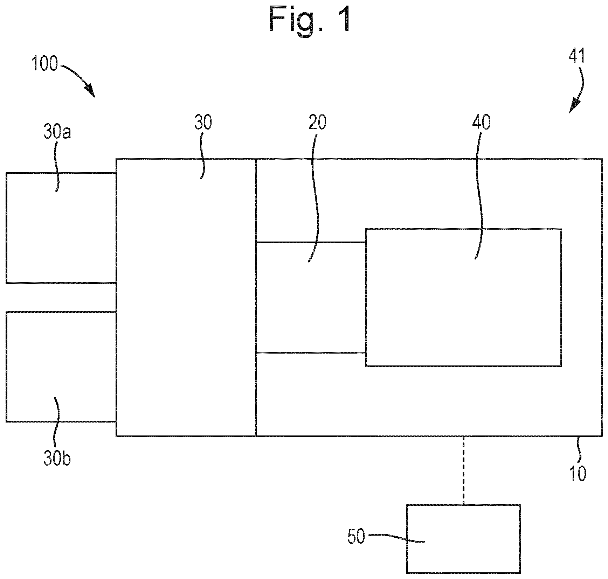

Reference is now made to **FIG. 1****,** which is a schematic diagram illustrating an exemplary charged particle beam assessment apparatus 100. It should be noted that the assessment apparatus comprises part of the assessment system, often the part of the assessment system situated in a fabrication facility. The assessment apparatus may cover a surface area of the fabrication facility floor referred to as an apparatus footprint. The other parts of the assessment system such as service systems of vacuum and fluid supplies and remote processing racks may be located elsewhere in the fabrication facility away from other fabrication systems and apparatus where space is a less significant requirement,

The charged particle beam assessment apparatus 100 of **FIG. 1** includes a main chamber 10, a load lock chamber 20, a charged particle assessment system 40 (which may also be called an electron beam system or tool), an equipment front end module (EFEM) 30 and a controller 50. The charged particle assessment system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be assessed e.g. measured or inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the charged particle assessment system 40 by which it may be assessed. The charged particle assessment system 40 comprises a charged particle device 41. The charged particle device 41 may be an electron-optical device, which may be synonymous with the electron-optical system. The charged particle device 41 may be a multi-beam charged particle device 41 configured to project a multi-beam towards the sample, for example the sub-beams being arranged with respect to each other in a multi-beam arrangement. Alternatively, the charged particle device 41 may be a single beam charged particle device 41 configured to project a single beam towards the sample.

The controller 50 is electronically connected to the charged particle assessment system 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it can be distributed over at least two of the component elements. While the present disclosure provides examples of the main chamber 10 housing an electron beam assessment apparatus, it should be noted that aspects of the disclosure in their broadest sense are not limited to a chamber housing an electron beam assessment apparatus. Rather, it is appreciated that the foregoing principles may also be applied to other tools and other arrangements of apparatus, that operate under the second pressure.

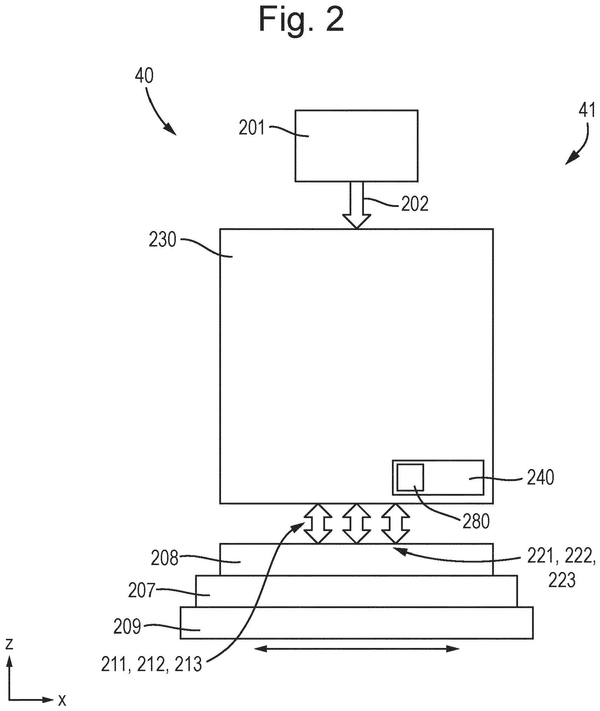

Reference is now made to **FIG. 2****,** which is a schematic diagram illustrating an exemplary charged particle assessment system 40 including a multi-beam charged particle device 41 that is part of the exemplary charged particle beam assessment apparatus 100 of **FIG. 1****.** The multi-beam charged particle device 41 comprises an electron source 201 and a projection apparatus 230. The charged particle assessment system 40 further comprises an actuated stage 209 and a sample holder 207. The sample holder may have a holding surface (not depicted) for supporting and holding the sample. Thus the sample holder may be configured to support the sample. Such a holding surface may be a electrostatic clamp operable to hold the sample during operation of the charged particle device 41 e.g. assessment such as measurement or inspection of at least part of the sample. The holding surface may be recessed into sample holder, for example a surface of the sample holder orientated to face the charged particle device 41. The electron source 201 and projection apparatus 230 may together be referred to as the charged particle device 41. The sample holder 207 is supported by actuated stage 209 so as to hold a sample 208 (e.g., a substrate or a mask) for assessment. The multi-beam charged particle device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209. The controller 50 may perform various image and signal processing functions. The controller 50 may also generate various control signals to govern operations of the charged particle beam assessment apparatus, including the charged particle multi-beam apparatus.

The projection apparatus 230 may be configured to focus sub-beams 211, 212, and 213 onto a sample 208 for assessment and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons. The secondary electrons typically have electron energy < 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding signals which are sent to a signal processing system 280, e.g. to construct images of the corresponding scanned areas of sample 208. The detector 240 may be incorporated into the projection apparatus 230.

The signal processing system 280 may comprise a circuit (not shown) configured to process signals from the detector 240 so as to form an image. The signal processing system 280 could otherwise be referred to as an image processing system. The signal processing system may be incorporated into a component of the multi-beam charged particle assessment system 40 such as the detector 240 (as shown in **FIG. 2**). However, the signal processing system 280 may be incorporated into any components of the assessment apparatus 100 or multi-beam charged particle assessment system 40, such as, as part of the projection apparatus 230 or the controller 50. The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive a signal from the detector 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under assessment. The reconstructed images can be used to reveal various features of the internal or external structures of the sample 208. The reconstructed images can thereby be used to reveal any defects that may exist in the sample.

The controller 50 may control the actuated stage 209 to move sample 208 during assessment, e.g. inspection, of the sample 208. The controller 50 may enable the actuated stage 209 to move the sample 208 in a direction, preferably continuously, for example at a constant speed, at least during sample assessment. The controller 50 may control movement of the actuated stage 209 so that it changes the speed of the movement of the sample 208 dependent on various parameters. For example, the controller 50 may control the stage speed (including its direction) depending on the characteristics of the assessment steps of scanning process.

Known multi-beam systems, such as the charged particle assessment system 40 and charged particle beam assessment apparatus 100 described above, are disclosed in US2020118784, US20200203116, US 2019/0259570 and US2019/0259564 which are hereby incorporated by reference.

As shown in **FIG. 2****,** in an embodiment the charged particle assessment system 40 has a single charged particle device 41 and optionally comprises a projection assembly 60. The projection assembly 60 may be a module and may be referred to as an ACC module. The projection assembly 60 is arranged to direct a light beam 62 such that the light beam 62 enters between the charged particle device 41 and the sample 208.

When the electron beam scans the sample 208, charges may be accumulated on the sample 208 due to large beam current, which may affect the quality of the image. To regulate the accumulated charges on the sample, the projection assembly 60 may be employed to illuminate the light beam 62 on the sample 208, so as to control the accumulated charges due to effects such as photoconductivity, photoelectric, or thermal effects.

There is a desire to increase the throughput of the assessment systems, such as for inspection, such that samples can be processed more quickly. One technique to increase the throughput of assessment systems is to reduce the amount of time the sample spends in an inspection position when inspection is not taking place. For example, during inspection, the sample may be at a high magnitude voltage of approximately 10 to 45 kV. It is common for the sample to be placed in an inspection position, for example on the sample stage, while the voltage of the sample is increased from a ground voltage to the high voltage. This means that the sample stage is occupied by a sample for a period of time during ramp up of the sample voltage from ground voltage to the high magnitude voltage before inspection, and during ramp down of the sample voltage from the high magnitude voltage to ground voltage after inspection. During these periods of time, which can be in the region of tens of seconds for each sample, the sample stage is not being used for sample inspection. As such, it may increase throughput if the voltage of the sample is ramped, partially or fully, up to the high magnitude voltage before the sample is placed on the sample stage and/or if the voltage of the sample is ramped, partially or fully, down to ground voltage after the sample is removed from the sample stage. In this way, there may be an increase throughput of samples because the sample stage can be more efficiently used to perform inspection by spending less time using the sample stage to ramp the magnitude of the voltage of the sample up and down.

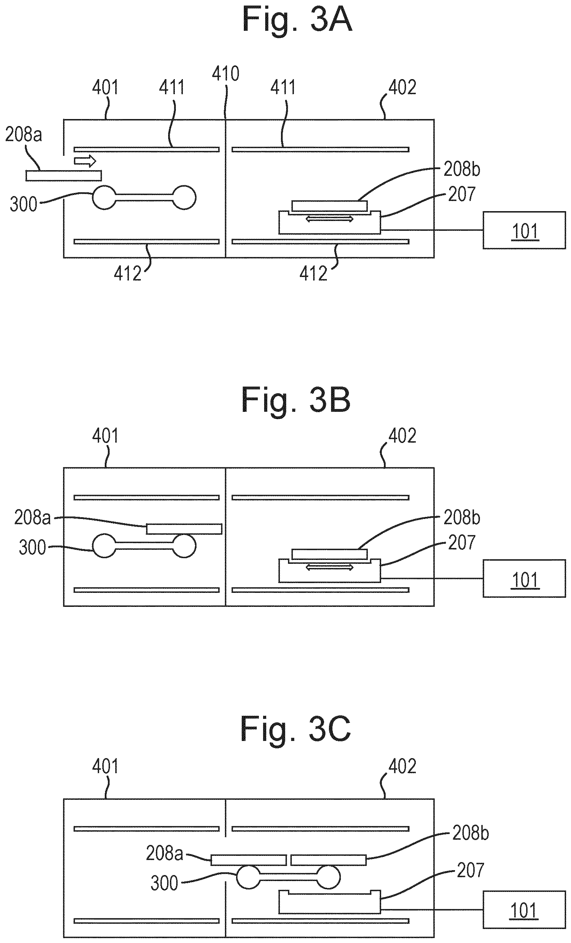

FIG. 3A-E illustrate steps of a method of loading a sample to a sample position. In particular, FIG. 3A-E illustrates an example of apparatus for loading the sample to a sample position on the sample stage, which may be a sample stage 209 as described above with reference to **FIG. 2****.** The term `ramping up' refers to increasing a magnitude of the voltage, such that the ramp up may be a ramp up from ground voltage to a negative voltage of a higher magnitude. Similarly, the term `ramping down' refers to decreasing a magnitude of the voltage.

As shown in each of FIG. 3A-E to 7A-E, the system comprises a sample holder 207 configured to support a sample 208a, 208b at a sample position. The system may further comprise a sample processor configured to process the sample 208a, 208b disposed at the sample position. The system also comprises a sample handler 300 configured to hold the sample 208a, 208b and transfer the sample 208a, 208b to and from the sample position on the sample holder 207. The system is configured to ramp up a voltage of the sample 208a, 208b from an initial voltage to a predetermined voltage, while the sample 208a, 208b is on the sample handler 300. The system may be a charged particle system 40. The sample holder may be a sample holder 207 as described above with reference to **FIG. 2****.** The sample holder 207 may be provided on an actuated stage 209 as described above with reference to **FIG. 2****.** Alternatively, the sample holder may be a stage.

The sample processor may be charged particle device 41, for example the charged particle device 41 as described above with reference to **FIG. 2****.** The sample processor is desirably configured to inspect a sample 208a, 208b disposed at the sample position.

The charged particle system may be controlled using a computer program. The computer program may comprise instructions configured to control the charged particle system. The instructions may comprise instructions configured to control the charged prticlar system to tramp the voltage of the sample 208a, 208b up and/or down and to transfer the sample to/from the sample holder 207 using the sample handler 300.

**FIG. 3A** depicts the loading of a sample 208a, having an initial voltage, on to a sample handler 300. **FIG. 3B** depicts ramping up the voltage of the sample from the initial voltage to a predetermined voltage. The ramping up of **FIG. 3B** is performed while the sample 208a is on the sample handler 300. As shown in **FIG. 3C****,** when the sample 208a is at the predetermined voltage, the sample 208a is transferred from the sample handler 300 to a sample position of a sample holder 207. The sample holder may be a sample holder 207 as described above with reference to **FIG. 2****.** The sample position of the sample holder is at the predetermined voltage. In other words, a contact portion of the sample holder may be configured to contact the sample when the sample is on the sample holder, and the contact portion is desirably at the predetermined voltage when the sample contacts the contact portion. Optionally, the entire sample holder may have the same voltage as the sample position, or contact portion, of the sample holder.

The sample handler 300 optionally transports the sample 208a from a first enclosure 401, in which the sample 208a is loaded on to the sample handler 300, to a second enclosure 402 in which the sample 208a is loaded on to the sample holder 207. The second enclosure 402 may be a vacuum chamber. The first chamber 401 may be a load lock chamber configured to act as an airlock between atmospheric conditions outside the first chamber 401 and the vacuum in the second enclosure 402.

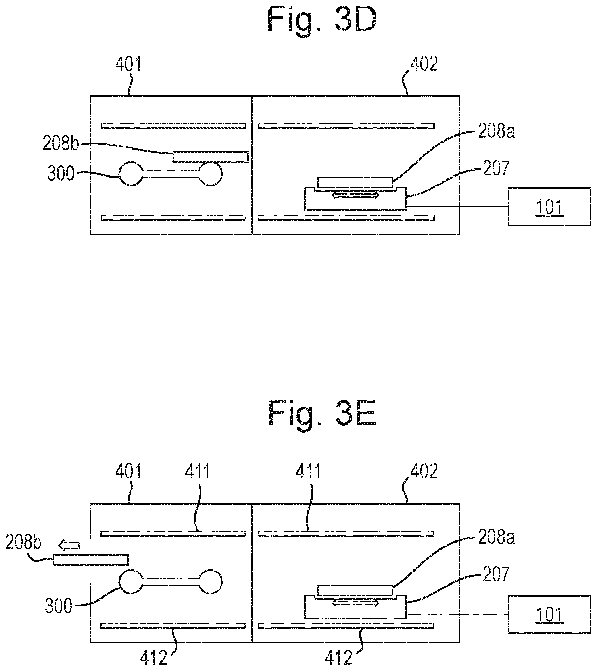

As shown in **FIG. 3D****,** the sample 208a may be left at the sample position, and maintained at the predetermined voltage, during processing the sample 208a at the sample position. In other words, if the sample position is on a sample stage 209 of a charged particle assessment system 40, the sample may remain in the sample position at the predetermined voltage throughout inspection of the sample 208a. It is desirable that the voltage of the sample is increased before the sample is placed at the sample position, such that the sample position is not occupied by the sample during increasing/decreasing the voltage of the sample from/to ground voltage.

As shown for example in **FIG. 3D****,** after a sample 208b has been processed, the sample 208b may be transferred from the sample position to the sample handler 300. Ramping the voltage of the sample 208b down to the initial voltage is desirably performed while the sample 208b is on the sample handler 300. As shown for example in **FIG. 3E****,** the sample 208b may be unloaded from the sample handler 300 once the voltage of the sample has been ramped down to the initial voltage.

With this approach, the sample position may be available to optionally be occupied by another sample 208b while the voltage of the sample 208a is being ramped up. As such, one sample 208b may be inspected at the same time as the voltage of a next sample 208a is being increased prior to inspection of the next sample 208a. Similarly, the sample position may be available to optionally be occupied by a sample 208a while the voltage of the other sample 208b is being ramped down. As such, one sample 208a may be inspected at the same time as the voltage of a prior sample 208b is being decreased. Each of the samples 208a, 208b, may be a sample 208 as described above with reference to **FIG. 2****.**

In other words, as shown for example in **FIG. 3A** the method may comprise a step of loading a further sample 208a, having the initial voltage, on to the sample handler 300. As shown for example in **FIG. 3B****,** the voltage of the further sample 208a from the initial voltage to the predetermined voltage may be performed while the further sample 208a is on the sample handler 300 and while the sample 208b is being processed. In other words, the next sample may be on the sample handler while the prior sample is in the sample position, and optionally the voltage of the next sample may be increased while the prior sample is in the sample position, and optionally while the prior sample is being processed (where the processing may include inspection). **FIG. 3C** shows an arrangement during a time at which, the further sample 208a is at the predetermined voltage and the sample 208b has been processed. In **FIG. 3C** the sample 208b is being transferred from the sample position on the sample holder to the sample handler 300. The further sample 208a is being transferred from the sample handler 300 to the sample position of the sample holder. The sample position of the sample holder is at the predetermined voltage during this transfer. In other words, the contact portion of the sample holder is at the predetermined voltage when the sample is made to contact the contact portion of the sample holder. The voltages of the samples are desirably within a predetermined threshold range of the voltage of the sample position, or contact portion, of the sample holder 300 when the samples are loaded on to the sample holder 300. As shown in the arrangement of **FIG. 3E****,** the further sample 208a may then be processed at the sample position, optionally while the voltage of the sample 208b is being ramped down.

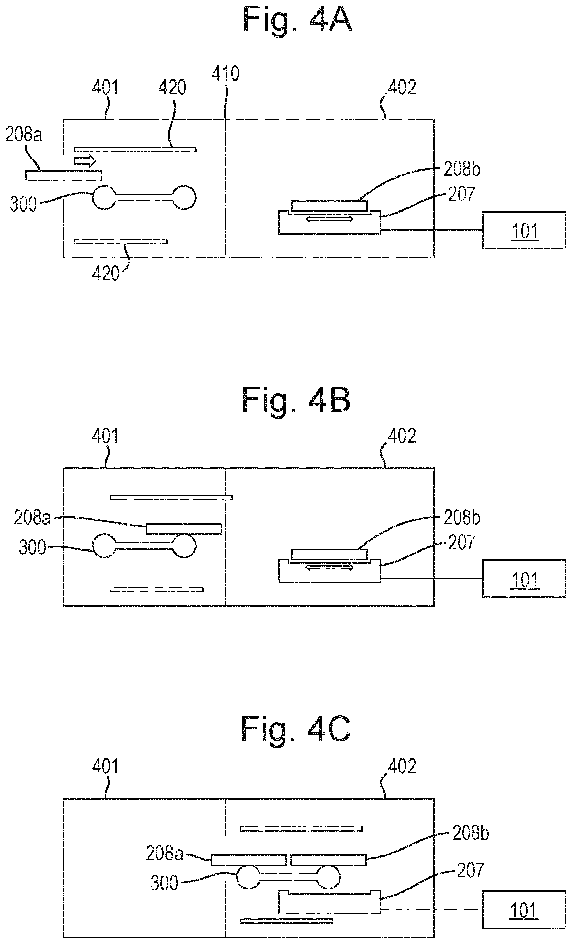

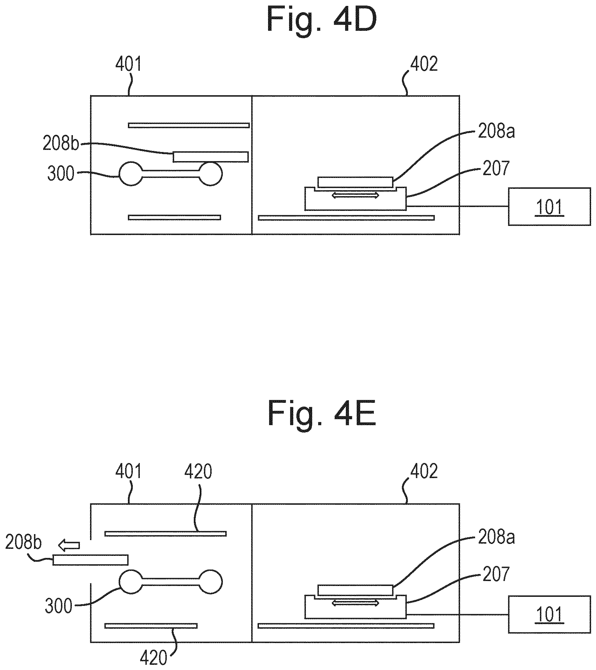

Similarly to FIG. 3A-E. each of FIGs. 4A-E to 7A-E illustrates steps of a method of loading a sample to a sample position. In particular, **FIGs. 4A**-E to 7A-E illustrate arrangements of apparatus for loading the sample to a sample position on the sample stage, which may be a sample stage 209 as described above with reference to **FIG. 2****.** The above description concerning the arrangement and method of FIG. 3A-E is also applicable to the arrangements and methods of **FIGs.**

### 4A-E to 7A-E.

The initial voltage is desirably ground voltage. In this way, the sample handler may be at ground voltage when the sample is transferred to/from the sample handler. This may enable a simple configuration of the sample handler as the sample handler may not be required to match a non-ground initial voltage of the sample. Alternatively, the initial voltage may have a magnitude greater than ground voltage. For example, the voltage of the sample may be raised to a higher magnitude voltage, e.g., a non-ground voltage, prior to transferring the sample to the sample handler. In this way the difference between the initial voltage and the predetermined voltage may be reduced.

The processing the sample may be performed while the sample is at a desired voltage. The desired voltage may have a magnitude greater than or equal to 3 kV, desirably between 5 kV and 50 kV, more desirably between 10 kV and 45 kV.

The desired voltage is desirably equal to the predetermined voltage. In this way, the sample may reach the desired voltage, at which the sample will be processed, before the sample is placed at the sample position. While the method is being performed, the sample position, or contact portion, of the sample holder is desirably maintained at the desired voltage. For example, as shown in **FIG. 3-7****,** a power supply 101 may be configured to supply power in order to maintain the sample holder at the desired voltage. This may desirably provide a simple sample holder arrangement avoiding the need for complex voltage control. This is especially relevant in scenarios where the sample holder is provided on an actuated stage 209, to keep the arrangement simple.

Alternatively, the predetermined voltage may have a lower or higher magnitude than the magnitude of the desired voltage. With this arrangement, after the sample is transferred from the sample holder to the sample position, and before the sample is processed, the voltage of the sample is increased or decreased from the predetermined voltage to the desired voltage. For example, the sample holder may be configured to increase, or decrease, the voltage of the sample from the predetermined voltage to the desired voltage prior to the sample being processed.

In the arrangement illustrated in FIG. 3A-E, the sample handler 300 is electrically insulated. In this way, the voltage of the sample 208a may not be changed directly by the sample handler 300. During ramping up of the voltage of the sample 208a, as shown in **FIG. 3B****,** the sample 208a and the sample handler 300 pass between two plates 411, 412. In other words, the plates 411, 412 are arranged on opposite sides of the path of the sample handler 300, such that one plate 411 is disposed on a first side of the path, and the other plate 412 is disposed on the opposite side of the path. One of the two plates 411 is at a higher magnitude voltage than the other of the two plates 412 while the sample handler 300 passes between the two plates. The two plates may extend from the sample holder 207 towards a path of the sample handler 300.

Ramping up the voltage of the sample 208a from the initial voltage to the predetermined voltage may comprise moving the sample 208a on the sample handler 300 between the two plates 411, 412 closer to the sample holder 207. In this way the sample holder 207 may impart a voltage to the sample 208a by capacitive coupling. In other words, the sample 208a may move between a lower magnitude voltage region, farther from the sample holder 207, and a higher magnitude voltage region closer to the sample holder 207. The two plates 411, 412 may extend along the path of the sample 208a between the lower magnitude voltage region and the higher magnitude voltage region, such that the sample 208a remains between the two plates 411, 412 as the sample 208a moves between the lower magnitude voltage region and the higher magnitude voltage region. In other words, the sample 208a may move between a lower magnitude voltage region, for example as shown in **FIG. 3B****,** to a higher magnitude voltage region, for example as shown in **FIG. 3C** in order to increase the voltage of the sample 208a to the predetermined voltage.

For example, as shown in FIG. 3A-E, each of the plates 411, 412 may be provided on opposite sides of the path of the sample handler 300 in a vertical direction. In other words, one of the plates 411 may be provided above the path of the sample handler 300, such that the sample 208a passes under the plate 411. The other of the plates 412 may be provided below the path of the sample handler 300, such that the sample 208a passes above the other plate 412. Alternatively, each of the plates 411, 412 may be provided on opposite sides of the path of the sample handler 300 in a horizontal direction.

While the voltage of the sample 208a is being ramped up, the sample holder 207 may be maintained at the predetermined voltage. For example, the power supply 101 may supply power to maintain the sample holder 207 at the predetermined voltage. In this way, the sample 208a and the sample holder 207 may be at approximately the same voltage when the sample 208a is transferred to the sample holder 207. Furthermore, the sample holder 207 may have sufficient voltage to raise the magnitude of the voltage of the sample 208a as the sample is moved closer to the sample holder 207. For example, the sample 208a may be moved from the first enclosure 401 to the second enclosure 402. Optionally, as shown in FIG. 3A-E, one or both of the plates 411, 412 may comprise a plurality of sub-plates separated by a gap. The gap may be disposed to accommodate a wall 410 between the first enclosure 401 and second enclosure 402. In other words, a first sub-plate of one or both of the two plates 411, 412 may be provided in the first enclosure 401, and a second sub-plate of one or both of the two plates 411, 412 may be provided in the second enclosure 402.

Similarly, ramping down the voltage of the sample 208b from the predetermined voltage to the initial voltage may comprises moving the sample 208b on the sample handler 300 between the two plates 411, 412 farther from the sample holder. The sample 208b may be transferred, on the sample handler 300, from a position adjacent the sample holder 207, as shown in **FIG. 3C****,** to a position farther from the sample holder 207, as shown in **FIG. 3D****.** For example, the sample 208b may be transferred from the second enclosure 402 to the first enclosure 401.

In the arrangement illustrated in FIG. 4A-E, the sample handler is electrically insulated. In this way, the voltage of the sample 208a may not be changed directly by the sample handler 300. During ramping up the voltage of the sample 208a, the sample 208a and the sample handler 300 are disposed within a conductive box 420. The conductive box 420 is conductive. The conductive box 420 may be an enclosed box or an open box. The conductive box 420 may comprise two plates each disposed on opposite sides of the sample handler 300.

In the arrangement shown in **FIG. 4B****,** ramping up the voltage of the sample 208a from the initial voltage to the predetermined voltage comprises moving the conductive box 420 closer to the sample holder 207. The sample holder 207 imparts a voltage to the conductive box 420 by capacitive coupling. In this way, the voltage of the conductive box 420 increases as the conductive box 420 approaches the sample holder 207. The conductive box 420 imparts a voltage to the sample 208a by capacitive coupling. In this way, the voltage of the sample 208a increases as the conductive box 420, containing the sample 208a, approaches the sample holder 207. In other words, the conductive box 420 may move between a lower magnitude voltage region, farther from the sample holder 207, and a higher magnitude voltage region closer to the sample holder 207. The conductive box 420 is desirably configured to reduce a potential difference across the sample 208a when one end of the sample 208a is nearer the lower magnitude voltage region and the other end of the sample 208a is nearer the higher magnitude voltage region.

While the voltage of the sample is being ramped up the sample holder 207 is desirably maintained at the predetermined voltage. For example, the power supply 101 may supply power to maintain the sample holder 207 at the predetermined voltage. In this way, the sample 208a and the sample holder 207 may be at approximately the same voltage when the sample 208a is transferred to the sample holder 207. Furthermore, the sample holder 207 may have sufficient voltage to raise the magnitude of the voltage of the conductive box 420, as the conductive box 420 is moved closer to the sample holder 207. For example, the conductive box 420 may be moved from the first enclosure 401 to the second enclosure 402.

Similarly, ramping down the voltage of the sample 208b from the predetermined voltage to the initial voltage may comprise moving the conductive box 420 farther from the sample holder 207, while the sample 208b and the sample handler 300 are disposed within the conductive box 420. The sample 208b may be transferred, on the sample handler 300, in the conductive box 420 from a position adjacent the sample holder 207, as shown in **FIG. 4C****,** to a position farther from the sample holder 207, as shown in **FIG. 4D****.**

The use of conductive capacitance to impart the voltage to the sample 208a in the arrangements of FIG. 3A-E and FIG. 4A-E may desirably enable the sample 208a to reach the predetermined voltage without the sample 208a having a direct connection to a power supply. The sample holder is likely to be part of a sample stage which may have a power supply for the purpose of actuation as well as for providing the voltage. As such, there may be an efficient use of the power supply of the stage instead of providing an additional power supply. Furthermore, the sample 208a and sample handler 300 may be more easily maneuvered if there is no direct connection between either of these components and a power supply.

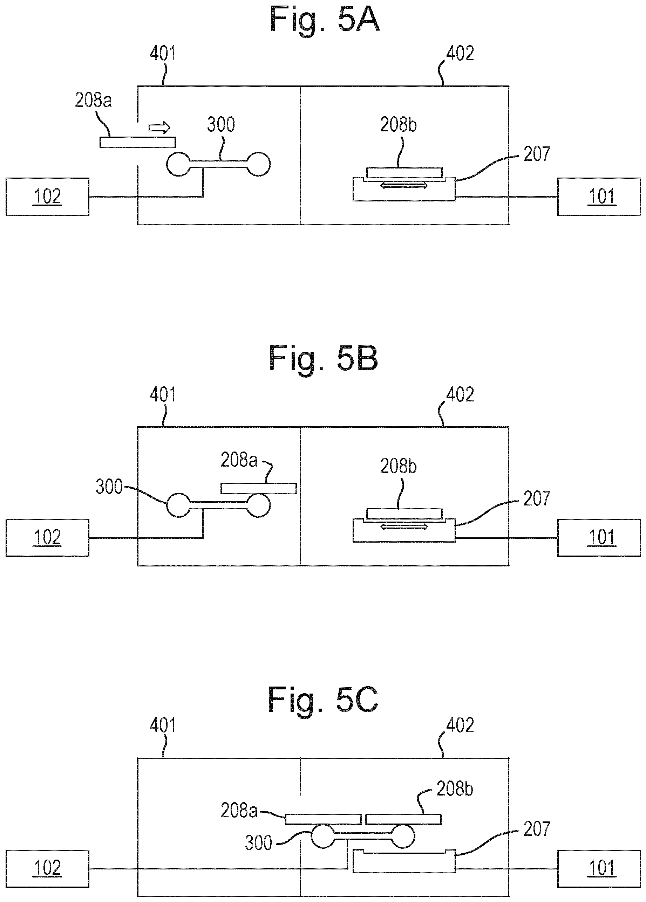

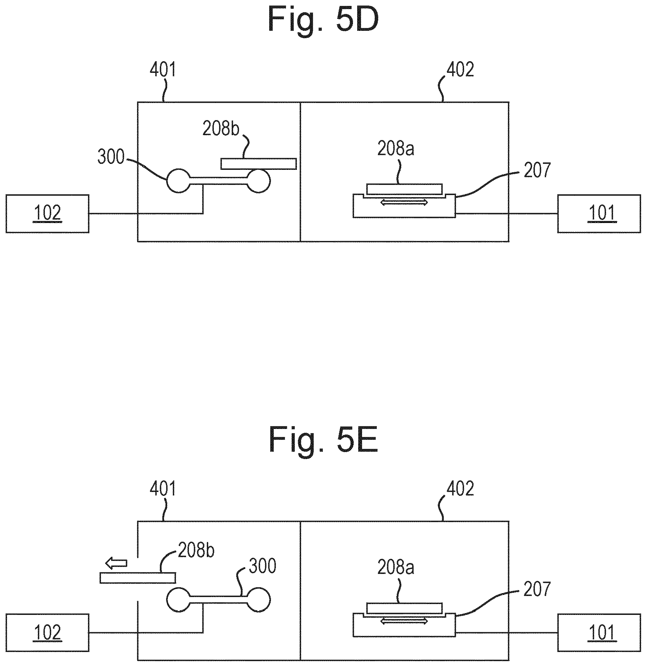

In the arrangement illustrated in FIG. 5A-E, the sample handler 300 is connected to a power supply 102. The sample handler 300 may be configured to impart a voltage to the sample when the sample is loaded on the sample handler. In other words, the sample handler 300 may be electrically conductive.

The power supply 102 may be controlled to ramp the voltage of the sample handler 300 up or down to a target voltage. The sample handler is electrically connected to the sample 208a such that the sample handler 300 is configured to impart the target voltage to the sample 208a.

During ramping up of the voltage of the sample 208a, the target voltage is desirably the predetermined voltage. In this way, the sample handler 300 may increase the voltage of the sample 208a to the predetermined voltage. The voltage of the sample handler 300 is preferably equal to, or within a predetermined range of, the voltage of the sample 208a when the sample 208a is loaded on to the sample handler 300. The power supply 102 may be controlled to set the voltage of the sample handler 300 as the initial voltage immediately prior to loading the sample 208a onto the sample handler 300.

During ramping down of the voltage of the sample 208b, the target voltage desirably the initial voltage. The voltage of the sample handler 300 is preferably equal to, or within a predetermined range of, the voltage of the sample 208a when the sample 208b is transferred from the sample holder 207 on to the sample handler 300 after processing of the sample 208b. The power supply 102 may be controlled to set the voltage of the sample handler 300 as the predetermined voltage immediately prior to transferring the sample 208b from the sample holder 207 on to the sample handler 300.

With this arrangement, the voltage of the sample handler 300, and thus the sample 208a, is controllable via the power supply 102. It may desirably be possible to more accurately achieve the chosen voltage of the sample 208a with this arrangement.

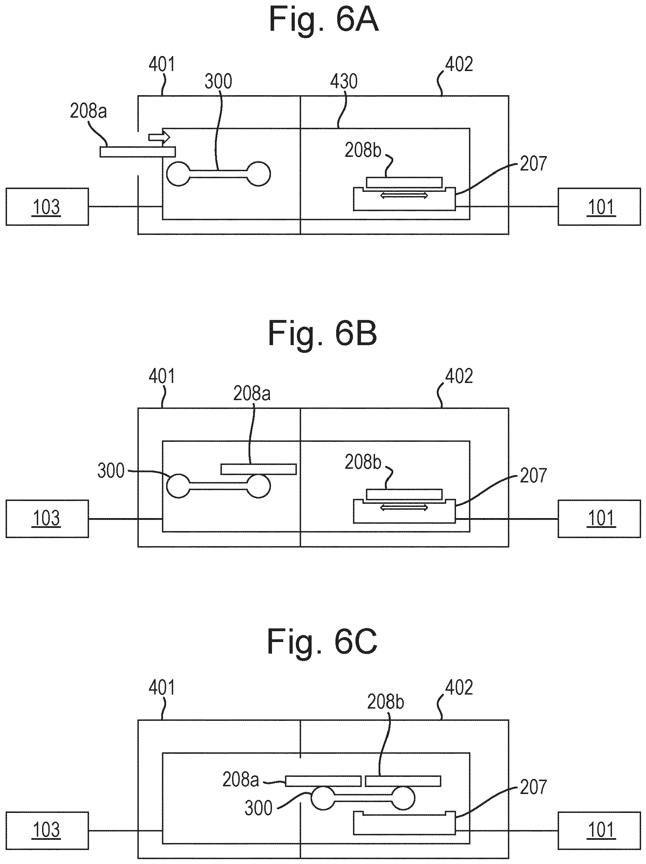

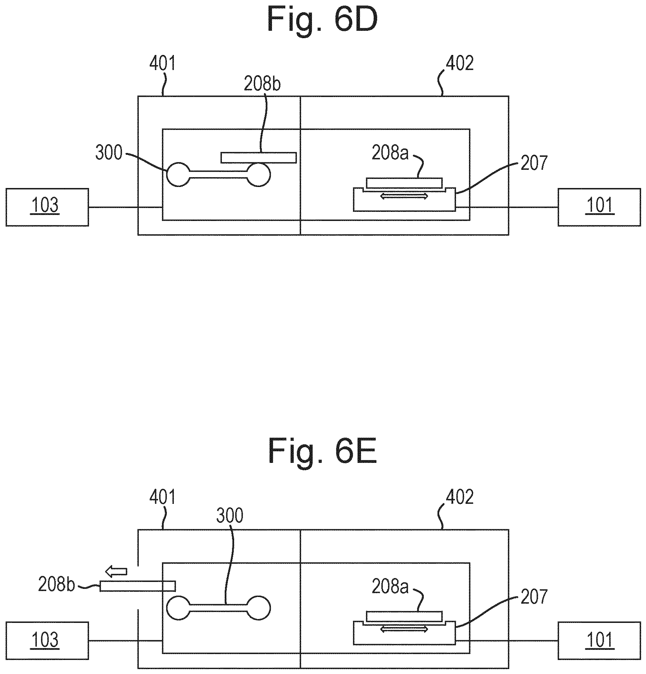

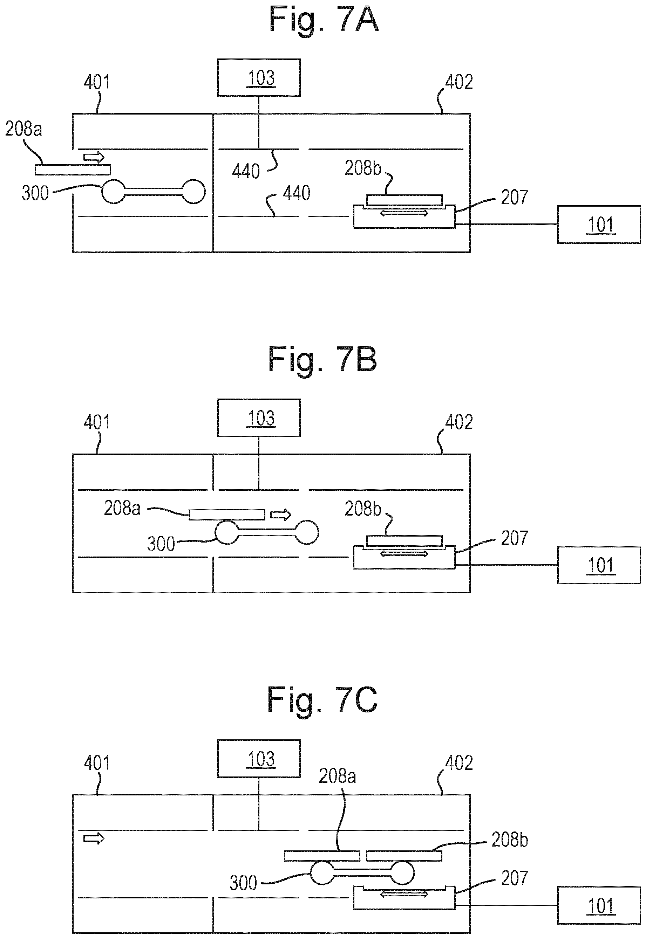

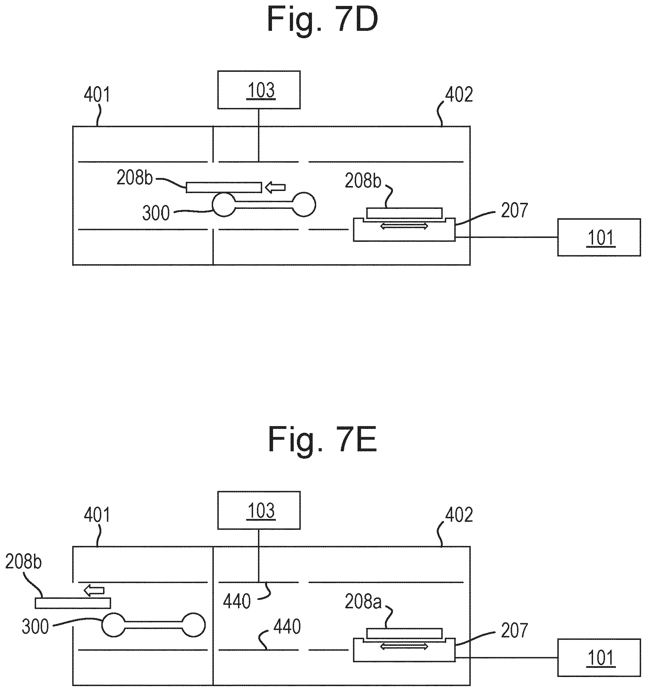

In the arrangement illustrated in FIGs. 6A-E and 7A-E, while the voltage of the sample 208a is being ramped up, the sample handler 300 is disposed within a voltage controlled enclosure 430, 440. The voltage controlled enclosure 430, 440is connected to a power supply 103. The voltage controlled enclosure 430, 440 is configured to impart a voltage to the sample 208a by capacitive coupling.

The power supply 103 may be controlled to ramp the voltage of the voltage controlled enclosure up or down to a target voltage.

During ramping up of the voltage of the sample 208a, the target voltage is desirably the predetermined voltage. In this way, the voltage controlled enclosure 430, 440 may increase the voltage of the sample 208a to the predetermined voltage. The power supply 103 may be controlled to set the voltage of the voltage controlled enclosure 430, 440 as the initial voltage immediately prior to loading the sample 208a onto the sample handler 300.

During ramping down of the voltage of the sample 208b, the target voltage desirably the initial voltage. The power supply 103 may be controlled to set the voltage of the voltage controlled enclosure 430, 440 as the predetermined voltage immediately prior to transferring the sample 208b from the sample holder 207 on to the sample handler 300.

The voltage controlled enclosure may enable the voltage to be set relatively accurately while also allowing the sample handler to maneuver relatively freely between the position at which the sample is loaded on the sampler handler and the position at which the sample is transferred to the sample holder.

In the arrangement illustrated in FIGs. 6A-E, the enclosure is a housing 430 configured to contain the sample 208a, 208b and the sample handler 300. The housing 430 preferably also contains the sample holder 207.

In the arrangement illustrated in FIGs. 7A-E, the enclosure is a tunnel 440. The sample handler 300 is configured to move through the tunnel 440 as part of a path from a position at which the sample 208a is loaded on the sample handler 300, as shown in **FIG. 7A****,** to the sample position of the sample holder 207, as shown in **FIG. 7C****.** The tunnel 440 may comprise two plates each disposed on opposite sides of the sample handler 300.

Loading the sample 208a on the sample handler is performed inside a chamber, such as the first enclosure 401. After the sample 208a is loaded on to the sample handler 300, the sample handler 300 may move from the first enclosure 401to the tunnel 440. While the sample 208a, and the sample handler 300 are in the tunnel 440, the power supply 103 may be controlled to set the tunnel 440 at the target voltage, which is desirably the predetermined voltage during ramping up. The sample handler 300 may move through the tunnel 440 as the voltage of the sample 208a is ramped up. Preferably, the sample handler 300 may pause in the tunnel 440 to allow the sample 208a time to reach the predetermined voltage. In this way the tunnel 440 need not be sufficiently longer than the length of the sample 208a.

After the sample 208b has been processed and is transferred from the sample holder 207 on to the sample handler 300, the sample handler 300 may move to the tunnel 440. While the sample 208b, and the sample handler 300 are in the tunnel 440, the power supply 103 may be controlled to set the tunnel 440 at the target voltage, which is desirably the initial voltage during ramping down. The sample handler 300 may move through the tunnel 440 as the voltage of the sample 208a is ramped down. Preferably, the sample handler 300 may pause in the tunnel 440 to allow the sample 208a time to approach, or reach, the initial voltage. In this way the tunnel 440 need not be sufficiently longer than the length of the sample 208b. The tunnel 440 may therefore make efficient use of limited space.

The tunnel 440 may, for example, be disposed between the first enclosure 401 and the second enclosure 402. The tunnel 440 may be disposed within a vacuum environment. Both the tunnel 440 and the sample holder 207 are desirably enclosed within the second enclosure 402, as shown in FIG. 7A-E.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies and or current supplies) to control the component to manipulate the charged particle beam in this manner. For example, a voltage supply may be electrically connected to one or more components, such as the elements 300' of the respective component, to apply potentials to the components, such as in a non-limited list the control lens array 250, the objective lens array 241, the condenser lens 231, correctors, a collimator element array and scan deflector array 260, under the control of the controller or control system or control unit. An actuatable component, such as a stage, may be controllable to actuate and thus move relative to another components such as the beam path using one or more controllers, control systems, or control units to control the actuation of the component.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). For example, the aperture arrays, plate electrodes of for example the objective lens array, one more features of the detector array, scan-deflector array and collimator element array, may be formed using MEMS manufacturing techniques.

References to upper and lower, up and down, above and below should be understood as referring to directions parallel to the (typically but not always vertical) upbeam and downbeam directions of the electron beam or multi-beam impinging on the sample 208. Thus, references to upbeam and downbeam are intended to refer to directions in respect of the beam path independently of any present gravitational field. These references are intended to correspond with the general direction of the electron beam from source to sample. However these references with respect to the beam path may correspond to references with respect to the electron-optical axis of device 41. For a multi-device 41, the direction of the beam path least one of the sub-devices 42 (a reference sub-device) may correspond to the electron-optical axis of the same sub-device 41. The other sub-devices of the multi-device 41 may be calibrated with respect to the reference sub-device. The electron-optical axis may correspond to a geometrical axis of the reference sub-device and, in an embodiment, of the multi-device,

An assessment system according to an embodiment of the disclosure may be a tool which makes a qualitative assessment of a sample (e.g. pass/fail), one which makes a quantitative measurement (e.g. the size of a feature) of a sample or one which generates an image of map of a sample. Examples of assessment systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical device 41 may be a component of a charged particle assessment system 40; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

The terms "sub-beam" and "beamlet" are used interchangeably herein and are both understood to encompass any radiation beam derived from a parent radiation beam by dividing or splitting the parent radiation beam. The term "beam" may be used synonymously with "sub-beam" and "beamlet". The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

Embodiments include the following numbered clauses:
1. A method of loading a sample to a sample position, the method comprising:
   loading a sample, having an initial voltage, on to a sample handler;
   ramping up the voltage of the sample from the initial voltage to a predetermined voltage, while the sample is on the sample handler;
   when the sample is at the predetermined voltage, transferring the sample from the sample handler to a sample position of a sample holder, wherein the sample position of the sample holder is at the predetermined voltage; and
   processing the sample at the sample position.
2. The method of clause 1, further comprising
   after the sample has been processed, transferring the sample from the sample position to the sample handler;
   ramping the voltage of the sample down to the initial voltage while the sample is on the sample handler; and
   unloading the sample from the sample handler once the voltage of the sample has been ramped down to the initial voltage.
3. The method of either of clauses 1 and 2, wherein the initial voltage is ground voltage.
4. The method of any of the preceding clauses, wherein the processing the sample is performed while the sample is at a desired voltage.
5. The method of clause 4, wherein the desired voltage is equal to the predetermined voltage.
6. The method of clause 5, wherein while the method is being performed, the sample holder is maintained at the desired voltage.
7. The method of clause 4, wherein after the sample is transferred from the sample holder to the sample position, and before the sample is processed, the voltage of the sample is increased or decreased from the predetermined voltage to the desired voltage.
8. The method of any of clauses 4 to 7, wherein the desired voltage is greater than or equal to 3 kV, desirably between 5 kV and 50 kV, more desirably between 10 kV and 45 kV.
9. The method of any of clauses 2 to 8, further comprising
   loading a further sample, having the initial voltage, on to the sample handler;
   ramping up the voltage of the further sample from the initial voltage to the predetermined voltage, while the further sample is on the sample handler and while the sample is being processed;
   when the further sample is at the predetermined voltage and the sample has been processed, transferring the further sample from the sample handler to the sample position of the sample holder, wherein the sample position of the sample holder is at the predetermined voltage; and
   processing the further sample at the sample position, while the voltage of the sample is being ramped down.
10. The method of clause any of the preceding clauses, wherein the sample handler is electrically insulated, and wherein during ramping up of the voltage of the sample, the sample and the sample handler pass between two plates, wherein one of the two plates is at a higher voltage than the other of the two plates, and wherein the two plates extend from the sample holder towards a path of the sample handler.
11. The method of clause 10, wherein ramping up the voltage of the sample from the initial voltage to the predetermined voltage comprises moving the sample on the sample handler between the two plates closer to the sample holder, and the sample holder imparting a voltage to the sample by capacitive coupling.
12. The method of clause 11, wherein while the voltage of the sample is being ramped up the sample position of the sample holder is maintained at the predetermined voltage.
13. The method of any of clauses 10 to 12, wherein ramping down the voltage of the sample from the predetermined voltage to the initial voltage comprises moving the sample on the sample handler between the two plates farther from the sample holder.
14. The method of clause any of clauses 1 to 9, wherein the sample handler is electrically insulated, and wherein during ramping up the voltage of the sample, the sample and the sample handler are disposed within a conductive box, wherein the conductive box has a greater conductivity than the conductivity of the sample.
15. The method of clause 14, wherein ramping up the voltage of the sample from the initial voltage to the predetermined voltage comprises moving the conductive box closer to the sample holder, wherein the sample holder imparts a voltage to the conductive box by capacitive coupling, and wherein the conductive box imparts a voltage to the sample by capacitive coupling.
16. The method of clause 15, wherein while the voltage of the sample is being ramped up the sample position of the sample holder is maintained at the predetermined voltage.
17. The method of any of clauses 14 to 16, wherein ramping down the voltage of the sample from the predetermined voltage to the initial voltage comprises moving the conductive box farther from the sample holder while the sample and the sample handler are disposed within the conductive box.
18. The method of any of clauses 1 to 9, wherein the sample handler is connected to a power supply.
19. The method of clause 18, wherein the power supply is controlled to ramp the voltage of the sample handler up or down to a target voltage, and wherein the sample handler is electrically connected to the sample such that the sample handler is configured to impart the target voltage to the sample.
20. The method of clause 19, wherein during ramping up the target voltage is the predetermined voltage, and during ramping down the target voltage is the initial voltage.
21. The method of any of clauses 1 to 9, wherein while the voltage of the sample is being ramped up, the sample handler is disposed within a voltage controlled enclosure,
   wherein the voltage controlled enclosure is connected to a power supply, and
   wherein the voltage controlled enclosure is configured to impart a voltage to the sample by capacitive coupling.
22. The method of clause 21, wherein the power supply is controlled to ramp the voltage of the voltage controlled enclosure up or down to a target voltage, wherein during ramping up the target voltage is the predetermined voltage, and during ramping down the target voltage is the initial voltage.
23. The method of either of clauses 21 and 22, wherein the enclosure is a housing containing the sample and the sample handler.
24. The method of clause 23, wherein the housing contains the sample holder.
25. The method of either of clauses 21 and 22, wherein the enclosure is a tunnel, wherein the sample handler is configured to move through the tunnel as part of a path from a position at which the sample is loaded on the sample handler to the sample position of the sample holder.
26. The method of clause 25, wherein loading the sample on the sample handler is performed inside a chamber, and wherein after the sample is loaded on to the sample handler, the sample handler moves from the chamber to the tunnel.
27. The method of clause 26, wherein the chamber is a load lock chamber and wherein the tunnel and the sample holder are disposed within a vacuum environment.
28. A computer program comprising instructions configured to control a charged particle system to perform the method of any of the preceding clauses, wherein the sample holder is a stage and wherein the processing at the sample position comprises inspection by a charged particle device.
29. A system for loading a sample to a sample position, the system comprising:
   a sample holder configured to support a sample at a sample position;
   a sample processor configured to process the sample disposed at the sample position; and
   a sample handler configured to hold the sample and transfer the sample to and from the sample position on the sample holder;
   wherein the system is configured to:
      ramp up a voltage of the sample from an initial voltage to a predetermined voltage, while the sample is on the sample handler; and/or
      ramp down a voltage of the sample from the predetermined voltage to the initial voltage, while the sample is on the sample handler.
30. The system of clause 29, wherein the system is a charged particle system and the sample holder is a stage.
31. The system of clause 30, wherein the sample processor is a charged particle device configured to inspect a sample disposed at the sample position.

## Claims

1. A method of loading a sample to a sample position, the method comprising:
loading a sample, having an initial voltage, on to a sample handler;
ramping up the voltage of the sample from the initial voltage to a predetermined voltage, while the sample is on the sample handler;
when the sample is at the predetermined voltage, transferring the sample from the sample handler to a sample position of a sample holder, wherein the sample position of the sample holder is at the predetermined voltage; and
processing the sample at the sample position.

2. The method of claim 1, further comprising
after the sample has been processed, transferring the sample from the sample position to the sample handler;
ramping the voltage of the sample down to the initial voltage while the sample is on the sample handler; and
unloading the sample from the sample handler once the voltage of the sample has been ramped down to the initial voltage.

3. The method of either of claims 1 and 2, wherein the initial voltage is ground voltage.

4. The method of any of the preceding claims, wherein the processing the sample is performed while the sample is at a desired voltage.

5. The method of any of claims 2 to 4, further comprising
loading a further sample, having the initial voltage, on to the sample handler;
ramping up the voltage of the further sample from the initial voltage to the predetermined voltage, while the further sample is on the sample handler and while the sample is being processed;
when the further sample is at the predetermined voltage and the sample has been processed, transferring the further sample from the sample handler to the sample position of the sample holder, wherein the sample position of the sample holder is at the predetermined voltage; and
processing the further sample at the sample position, while the voltage of the sample is being ramped down.

6. The method of any of the preceding claims, wherein the sample handler is electrically insulated, and wherein during ramping up of the voltage of the sample, the sample and the sample handler pass between two plates, wherein one of the two plates is at a higher voltage than the other of the two plates, and wherein the two plates extend from the sample holder towards a path of the sample handler.

7. The method of claim 6, wherein ramping up the voltage of the sample from the initial voltage to the predetermined voltage comprises moving the sample on the sample handler between the two plates closer to the sample holder, and the sample holder imparting a voltage to the sample by capacitive coupling.

8. The method of any of claims 1 to 5, wherein the sample handler is electrically insulated, and wherein during ramping up the voltage of the sample, the sample and the sample handler are disposed within a conductive box.

9. The method of any of claims 1 to 5, wherein the sample handler is connected to a power supply.

10. The method of claim 9, wherein the power supply is controlled to ramp the voltage of the sample handler up or down to a target voltage, and wherein the sample handler is electrically connected to the sample such that the sample handler is configured to impart the target voltage to the sample.

11. The method of any of claims 1 to 5, wherein while the voltage of the sample is being ramped up, the sample handler is disposed within a voltage controlled enclosure,
wherein the voltage controlled enclosure is connected to a power supply, and
wherein the voltage controlled enclosure is configured to impart a voltage to the sample by capacitive coupling.

12. A computer program comprising instructions configured to control a charged particle system to perform the method of any of the preceding claims, wherein the sample holder is a stage and wherein the processing at the sample position comprises inspection by a charged particle device.

13. A system for loading a sample to a sample position, the system comprising:
a sample holder configured to support a sample at a sample position;
a sample processor configured to process the sample disposed at the sample position; and
a sample handler configured to hold the sample and transfer the sample to and from the sample position on the sample holder;
wherein the system is configured to:
ramp up a voltage of the sample from an initial voltage to a predetermined voltage, while the sample is on the sample handler; and/or
ramp down a voltage of the sample from the predetermined voltage to the initial voltage, while the sample is on the sample handler.

14. The system of claim 13, wherein the system is a charged particle system and the sample holder is a stage.

15. The system of claim 14, wherein the sample processor is a charged particle device configured to inspect a sample disposed at the sample position.
